# EUROPÄISCHE PATENTANMELDUNG

(11) **EP 1 158 538 A2**
(43) Veröffentlichungstag der Anmeldung: **28.11.2001**
(21) Anmeldenummer: 01111693.6
(22) Anmeldetag: 14.05.2001
(51) Int. Cl.: G11C 17/18

(54) **Verfahren zum Auslesen von elektrischen Schmelzsicherungen und Antischmelzsicherungen**

(30) Priorität: 26.05.2000 DE 10026243
(71) Anmelder: Infineon Technologies AG, 81669 München (DE)
(72) Erfinder: Kaiser, Robert, 86916 Kaufering (DE); Lindolf, Jürgen, Dr., 86316 Friedberg (DE); Schneider, Helmut, 80993 München (DE)
(74) Vertreter: Müller . Hoffmann & Partner Patentanwälte

(57) **Zusammenfassung**

Die Erfindung betrifft ein Verfahren zum Auslesen von elektrischen Fuses/Antifuses (2) in einer Halbleiterspeicheranordnung, wie insbesondere einem DRAM. Für das Auslesen der Fuses/Antifuses wird anstelle der bisher üblichen internen Spannung (Vint) die das hohe Potential der Bitleitungen (BL) eines Speicherzellenfeldes (6) definierende Spannung (Vblh) herangezogen.

## Beschreibung

Die vorliegende Erfindung betrifft ein Verfahren zum Auslesen von elektrischen Fuses/Antifuses (Fuses sind elektrische Durchschlagstrecken oder Schmelzbrücken bzw. "Sicherungen") in einer Halbleiterspeicheranordnung, bei dem der Zustand einer Fuse/Antifuse durch Anlegen einer Spannung an die Fuse/Antifuse ausgelesen wird, wobei in der Halbleiterspeicheranordnung das hohe Potential von Bitleitungen eines Speicherzellenfeldes über eine gegenüber einer internen Spannung Vint der Halbleiterspeicheranordnung reduzierte Spannung Vblh definiert wird.

In integrierten Schaltungen, wie insbesondere in Halbleiterspeicheranordnungen, werden in zunehmendem Maß elektrisch brennbare Fuses/Antifuses eingesetzt, die durch Brennen jeweils entweder angeschaltet (Antifuse) oder ausgeschaltet (Fuse) werden können. Eine durch Brennen ausschaltbare Fuse wird durch den Brennvorgang durchtrennt und auch als normale "Efuse" bezeichnet. Dagegen wird eine durch Brennen anschaltbare Fuse durch den Brennvorgang angeschaltet und als "Antifuse" bezeichnet. Eine solche Antifuse wird also durch das Brennen leitfähig gemacht. Im folgenden soll unter "Fuse" sowohl eine "Efuse" als auch eine "Antifuse" (bei entsprechender Umkehr des Resultats des Brennvorgangs) verstanden werden.

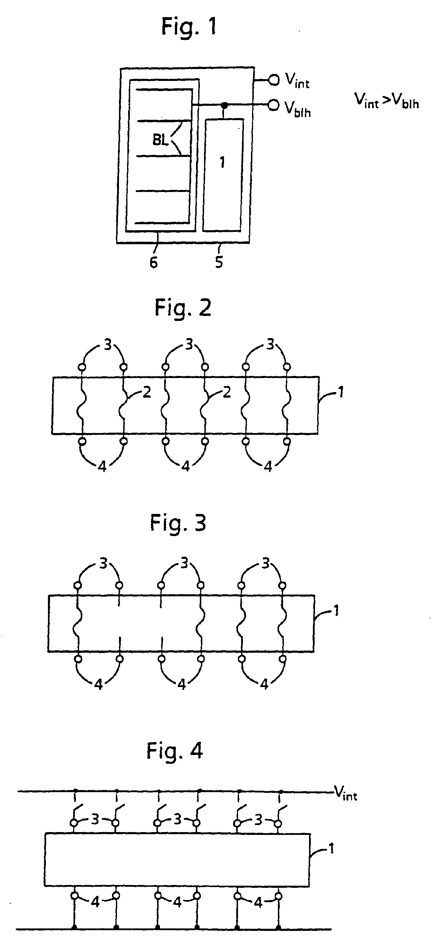

Fig. 2 zeigt eine Fuseanordnung 1 mit verschiedenen Fuses 2, die zwischen Anschlüssen 3, 4 liegen. Werden nun solche Fuses, im vorliegenden Fall "Efuses", gebrannt, so wird die elektrische Verbindung zwischen den Anschlüssen 3 und 4 unterbrochen, wie dies in Fig. 3 für zwei Fuses 2 schematisch angedeutet ist. Dieses Brennen kann durch Anlegen entsprechend hoher elektrischer Spannungen zwischen jeweiligen Anschlüssen 3, 4 oder durch Einwirkung eines Laserstrahles erfolgen.

Das Auslesen von Fuses erfolgt derzeit hauptsächlich mit Hilfe der sogenannten internen Chipspannung Vint, die im Chip jeder Halbleiterspeicheranordnung zur Verfügung steht und etwa 2 V beträgt, oder der externen Versorgungsspannung Vdd. Fig. 4 zeigt eine hierfür geeignete Schaltungsanordnung, mit der den einzelnen Anschlüssen 3 der Fuseanordnung 1 über Schalter die interne Chipspannung Vint zugeführt werden kann. Ist eine Fuse nicht-leitend, also gebrannt, so kann dies als logischer Zustand "1" (oder "0") bewertet werden. Ist dagegen eine Fuse leitend, also nicht gebrannt, wird dies dann als Zustand "0" (oder "1") festgestellt.

Die Erfinder der vorliegenden Anmeldung haben nun als erste erkannt, daß das Auslesen von Fuses mittels der internen Chipspannung Vint, die in der Größenordnung von 2 V liegt, zu Problemen führen kann: das Anlegen einer solch hohen Spannung bewirkt nämlich einen relativ schnellen Alterungsprozeß und kann so schließlich sogar ein unbeabsichtigtes Brennen bisher ungebrannter Fuses herbeiführen.

Es ist daher Aufgabe der vorliegenden Erfindung, ein Verfahren zum Auslesen von elektrischen Fuses anzugeben, bei dem schnelle Alterungsprozesse und ein unbeabsichtigtes Brennen bisher ungebrannter Fuses/Antifuses zuverlässig vermieden werden.

Diese Aufgabe wird bei einem Verfahren der eingangs genannten Art erfindungsgemäß dadurch gelöst, daß das Auslesen der Fuses/Antifuses durch Anlegen der reduzierten Spannung Vblh vorgenommen wird.

In Halbleiterspeicheranordnungen, wie beispielsweise DRAMs, wird das hohe Potential der Bitleitungen bekanntlich durch die Spannung Vblh definiert. Diese Spannung Vblh beträgt etwa 1,6 V und ist somit um 20 bis 30 % gegenüber der internen Chipspannung Vint reduziert. Wird nun zum Auslesen der Fuses/Antifuses anstelle der bisher üblichen internen Chipspannung Vint die das hohe Potential der Bitleitungen definierende reduzierte Spannung Vblh herangezogen, dann kann infolge der dadurch bewirkten Spannungsreduktion von etwa 2 V auf etwa 1,6 V die mittlere Lebensdauer von Fuses (Efuses und Antifuses) um etwa 1,6 Dekaden, also um einen Faktor 16, gesteigert werden, wie Versuche der Erfinder gezeigt haben. Diese erhebliche Erhöhung der Lebensdauer durch eine relativ geringfügige Reduktion der Auslesespannung der Fuses/Antifuses ist vollkommen überraschend und nicht vorherzusehen: durch die relativ geringfügige Reduktion der Lesespannung um 20 bis 30 % kann nämlich eine Steigerung der Lebensdauer um 1,6 Dekaden, also 1600 %, erreicht werden. In bezug auf diese Steigerung der Lebensdauer hat sich die Erfindung für Antifuses als noch vorteilhafter als für Efuses erwiesen.

Nachfolgend wird die Erfindung anhand der Zeichnungen näher erläutert. Es zeigen:
- Fig. 1: eine schematische Darstellung eines Halbleiterchips mit einer Fuseanordnung und einem Speicherzellenfeld,
- Fig. 2: eine schematische Darstellung einer Fuseanordnung,
- Fig. 3: eine schematische Darstellung der Fuseanordnung von Fig. 2, wobei einige Fuses gebrannt sind, und
- Fig. 4: eine schematische Darstellung einer Schaltungsanordnung, die zum Auslesen der Fuseanordnung von Fig. 2 bzw. 3 geeignet ist.

Die Fig. 2 bis 4 sind bereits eingangs erläutert worden. In den Figuren werden für einander entsprechende Bauteile jeweils die gleichen Bezugszeichen verwendet.

Fig. 1 zeigt einen Halbleiterchip 5 mit einer Fuseanordnung 1 und einem Speicherzellenfeld 6 mit Bitleitungen BL. Der Halbleiterchip 5 verfügt über eine interne Chipspannung Vint, die etwa 2 V beträgt und bisher unter anderem auch zum Auslesen der Fuses der Fuseanordnung 1 herangezogen wird.

Den Bitleitungen BL ist eine Spannung Vblh zuführbar, die etwa 1,6 V beträgt und das hohe Potential dieser Bitleitungen BL definiert.

Erfindungsgemäß wird nun die Spannung Vblh auch zum Auslesen der Fuses der Fuseanordnung 1 herangezogen. Durch die relativ geringe Reduktion der Auslesespannung von der internen Chipspannung Vint auf die das hohe Potential der Bitleitungen BL definierenden Spannung Vblh kann eine erhebliche Steigerung der Lebensdauer der Fuses der Fuseanordnung 1 um etwa 1,5 Dekaden, also um einen Faktor 16, erreicht werden. Die Spannung Vblh ist dabei noch ausreichend groß, um ein zuverlässiges Auslesen bzw. Bewerten des Zustandes der einzelnen Fuses 2 sicherzustellen.

Bezugszeichenliste
- 1: Fuseanordnung
- 2: Fuse/Antifuse
- 3: Anschluß
- 4: Anschluß
- 5: Chip
- 6: Speicherzellenfeld
- BL: Bitleitung
- Vint: Interne Spannung des Chips
- Vdd: Externe Spannung des Chips
- Vblh: Hohes Potential der Bitleitungen BL definierende Spannung

## Patentansprüche

1. Verfahren zum Auslesen von elektrischen Fuses/Antifuses (2) in einer Halbleiterspeicheranordnung, bei dem der Zustand einer Fuse/Antifuse (2) durch Anlegen einer Spannung an die Fuse/Antifuse (2) ausgelesen wird, wobei in der Halbleiterspeicheranordnung das hohe Potential von Bitleitungen (BL) eines Speicherzellenfeldes (6) über eine gegenüber einer internen Spannung (Vint) der Halbleiterspeicheranordnung reduzierte Spannung (Vblh) definiert wird,
**dadurch gekennzeichnet, daß** das Auslesen der Fuses/Antifuses durch Anlegen der reduzierten Spannung (Vblh) vorgenommen wird.

2. Verfahren nach Anspruch 1,
**dadurch gekennzeichnet, daß** die reduzierte Spannung (Vblh) um etwa 20 bis 30 % gegenüber der internen Spannung reduziert ist.

3. Verfahren nach Anspruch 1 oder 2,
**dadurch gekennzeichnet, daß** die interne Spannung (Vint) etwa 2 V und die reduzierte Spannung (Vblh) etwa 1,6 V betragen.
